Europäisches Patentamt

European Patent Office

Office européen des brevets

(11) Numéro de publication : **0 489 624 B1**

# (12) FASCICULE DE BREVET EUROPEEN

(45) Date de publication du fascicule du brevet :
30.08.95 Bulletin 95/35

(51) Int. Cl.⁶ : **H01L 39/16, H01L 39/22**

(21) Numéro de dépôt : **91403211.5**

(22) Date de dépôt : **27.11.91**

(54) **Cellule de commutation électrique et ses utilisations.**

(30) Priorité : **05.12.90 FR 9015203**

(43) Date de publication de la demande :
**10.06.92 Bulletin 92/24**

(45) Mention de la délivrance du brevet :
**30.08.95 Bulletin 95/35**

(84) Etats contractants désignés :
**DE ES FR GB IT NL**

(56) Documents cités :
EP-A- 0 397 186
US-A- 3 115 612
**IEEE TRANSACTIONS ON MAGNETICS vol.
27, no. 2, Mars 1991, NEW YORK, US pages
2863 - 2866 Harada Y. et al 'Artificial neural
network circuits with Josephson devices' &
APPLIED SUPERCONDUCTIVITY CONFE-
RENCE Septembre 1990, SNOWMASS, US**

(56) Documents cités :
**W.BUCKEL 'Supraleitung - Grundlagen und
Anwendung' 1972 , PHYSIK VERLAG, WEIN-
HEIM, D
PATENT ABSTRACTS OF JAPAN vol. 15, no.
54 (E-1031)8 Février 1991 & JP-A-22 81 765
PATENT ABSTRACTS OF JAPAN vol. 15, no.
54 (E-1031) 8 Fevrier 1991 & JP-A-22 81 766**

(73) Titulaire : **L'AIR LIQUIDE, SOCIETE ANONYME
POUR L'ETUDE ET L'EXPLOITATION DES
PROCEDES GEORGES CLAUDE
75, Quai d'Orsay
F-75321 Paris Cédex 07 (FR)**

(72) Inventeur : **Karanthi, Pierre
66 rue Anatole France
F-78350 Jouy en Josas (FR)**

(74) Mandataire : **Le Moenner, Gabriel et al
L'AIR LIQUIDE, Société Anonyme
pour l'étude et l'exploitation des procédés
Georges Claude
75, Quai d'Orsay
F-75321 Paris Cédex 07 (FR)**

EP 0 489 624 B1

# Description

La présente invention est relative à une cellule de commutation électrique et, plus particulièrement, à une telle cellule exploitant une transition d'un matériau entre un état supraconducteur et un état résistant. La présente invention est aussi relative à diverses utilisations d'une telle cellule.

On connaît des systèmes logiques construits à partir de cellules de commutation basées sur l'effet Josephson, suivant lequel un courant électrique peut franchir une mince barrière isolante séparant deux métaux supraconducteurs. A titre d'exemple d'une telle cellule, on peut citer la jonction tunnel Nb-Al$_2$O$_x$-Nb qui permet de réaliser des portes logiques rapides et consommant peu d'énergie. Cependant les technologies actuelles de réalisation de telles portes sont limitées à l'utilisation de matériaux présentant un état supraconducteur à des températures très basses inférieures à 20 K, typiquement 4 K, qui ne peuvent être atteintes à des coûts acceptables permettant d'envisager des applications industrielles de telles cellules.

La présente invention a donc pour but de réaliser une cellule de commutation électrique qui n'exige pas d'emploi de moyens de réfrigération d'un coût prohibitif excluant toute application industrielle de ladite cellule.

La présente invention a aussi pour but de réaliser une telle cellule utilisable notamment comme porte logique ou comme élément d'un réseau "neuronal".

On atteint ces buts de l'invention, ainsi que d'autres qui apparaîtront dans la suite de la présente description, avec une cellule de commutation électrique comprenant un premier canal en un matériau présentant un état supraconducteur et un état résistant, des moyens de réfrigération pour maintenir ledit premier canal à une température inférieure à celle qui assure la supraconductivité du matériau en dessous d'une intensité de courant critique dans le canal, des moyens d'alimentation électrique dudit canal et des moyens pour régler l'intensité du courant électrique circulant dans le canal de manière à établir sélectivement le canal dans son état supraconducteur ou son état résistant. Suivant l'invention, la cellule comprend en outre un deuxième canal en un matériau conducteur de l'électricité, connecté en parallèle sur le premier canal de manière que la tension aux bornes du deuxième canal soit sensiblement nulle lorsque le premier canal est dans son état supraconducteur et non nulle lorsque le premier canal est dans son état résistant.

Ainsi, une commande en courant permet d'établir la cellule dans l'un ou l'autre de deux états bien différenciés, séparés électriquement par un seuil de tension bien défini. Une simple mesure de tension, d'intensité ou de flux magnétique permet alors de détecter l'état de la cellule et les commutations de cette cellule d'un état vers l'autre et inversement. Une telle cellule trouve application dans des systèmes logiques, des calculateurs numériques, des réseaux "neuronaux", des convertisseurs analogiques-numériques, etc..., comme on le verra plus loin.

Suivant une caractéristique importante de la cellule selon l'invention, le matériau utilisé pour constituer le premier canal est un matériau supraconducteur à une température relativement élevée, susceptible d'être atteinte avec des moyens de réfrigération industriels tels que l'azote ou l'hélium liquides. Comme on le verra dans la suite, on connaît à l'heure actuelle des céramiques et des alliages métalliques présentant cette propriété.

D'autres caractéristiques et avantages de la cellule de commutation électrique suivant la présente invention apparaîtront à la lecture de la description qui va suivre et à l'examen du dessin annexé dans lequel :

- la figure 1 représente schématiquement la cellule de commutation suivant la présente invention,
- la figure 2 représente une variante de la cellule de la figure 1,
- la figure 3 représente des graphes des caractéristiques tension/courant des cellules des figures 1 et 2,
- la figure 4 représente schématiquement une variante de la cellule de la figure 2, et
- les figures 5 et 6 représentent schématiquement diverses associations de cellules suivant l'invention.

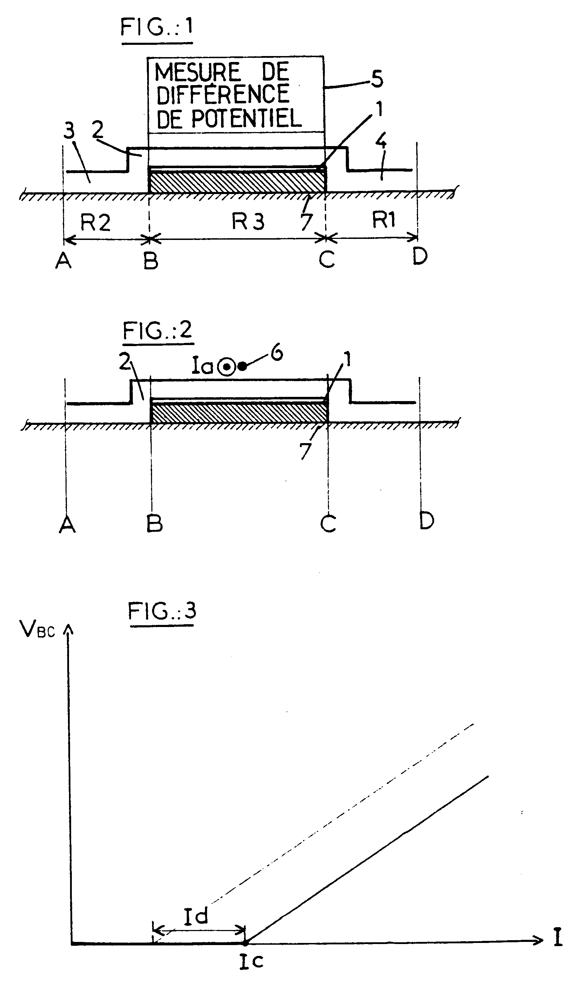

On se réfère à la figure 1 du dessin annexé où la cellule suivant l'invention est schématisée par un premier canal 1 en un matériau présentant un état supraconducteur, déposé sur un substrat 7 approprié, généralement isolant, et surmonté d'un deuxième canal 2 en un métal conducteur ne présentant pas d'état supraconducteur. Ces deux canaux prennent la forme de bandes de films minces représentées en coupe longitudinale à la figure. Les deux canaux sont ainsi connectés en parallèle entre des sections B et C, des bornes de contact électrique 3 et 4 étant établies dans des zones [A,B] et [C,D] d'extrémité pour l'alimentation électrique de la cellule par des moyens non représentés. Des moyens de mesure 5 du potentiel ou de l'intensité entre les sections B, C sont prévus pour surveiller l'état de la cellule. Des moyens de réfrigération (non représentés) assurent le maintien de la cellule à une température inférieure à la température de transition du matériau supraconducteur utilisé pour constituer le premier canal 1.

On se réfère maintenant au graphe de la figure 3 pour expliquer le fonctionnement de la cellule suivant l'invention. Sur ce graphe on a représenté en trait plein la caractéristique tension $V_{BC}$/courant I dans la cellule. L'intensité $I_c$ est l'intensité critique du courant dans le supraconducteur, intensité au-dessus de laquelle, à la température établie par les moyens de réfrigération, le matériau supraconducteur perd sa supraconductivité pour devenir résistant électriquement.

Ainsi, aussi longtemps que l'intensité du courant établie dans la cellule par des moyens de réglage (non représentés) des moyens d'alimentation électrique reste inférieure à l'intensité critique $I_c$, tout le courant passe dans le canal supraconducteur 1 et la tension $V_{BC}$ reste sensiblement nulle.

Si on fait croître le courant dans la cellule et qu'on atteint alors l'intensité critique $I_c$, le canal 1 passe de son état supraconducteur à un état résistant et le courant injecté dans la cellule passe alors partiellement par le canal conducteur 2 dont la résistance fait apparaître une différence de potentiel entre B et C. Cette différence de potentiel est régie par la loi d'Ohm :

$$V_{BC} = R(I - I_c)$$

R étant la résistance du canal conducteur 2. A l'intensité critique $I_c$, la tension croît avec pour pente la résistance R du canal conducteur 2.

A titre d'exemple non limitatif, une telle cellule peut être réalisée avec un matériau supraconducteur tel qu'une céramique du type YBaCuO par exemple, présentant un courant de transition $I_c$ de 5000 A/cm$^2$ à 77 K (température établie par des moyens de réfrigération à l'azote liquide), la température de transition du matériau étant de 95 K. D'autres matériaux supraconducteurs pourraient être utilisés, tels que les alliages métalliques du type NbTi mais à une température beaucoup plus basse (4 K par exemple).

Le canal 1 prend la forme d'un dépôt de 0,2 μm d'épaisseur de supraconducteur céramique, s'étendant sur 10 μm de largeur et 100 μm de longueur, le courant critique $I_c$ étant alors de 100 μA.

Le canal 2 peut être constitué d'une couche métallique de 0,02 μm d'épaisseur de cuivre ou d'argent par exemple, de 100 μm de longueur et 10 μm de largeur, déposée éventuellement sur la couche supraconductrice. On peut estimer à 1 ohm la résistance de ce canal entre B et C. La somme des résistances des parties 3 et 4 peut être du même ordre. Quand l'intensité est supérieure à $I_c$ la section BC est parcourue par un courant sous une différence de potentiel $V_{BC}$ de l'ordre de 100 μV. La puissance dissipée dans la cellule entre A et D, est de l'ordre de 10$^{-8}$ watt, ce qui est négligeable. Dans l'hypothèse évoquée plus haut où une cellule selon l'invention serait utilisée dans un réseau neuronal comptant par exemple 10$^6$ cellules, la consommation de puissance resterait de l'ordre de quelques dizaines de mW pour l'ensemble du réseau, ce qui est non moins négligeable.

On a représenté à la figure 2 du dessin une variante de la cellule suivant l'invention, plus particulièrement adaptée à un emploi dans un tel réseau neuronal. A cette figure, comme dans toutes les suivantes, les repères 1, 2, 3 et 4 désignent des éléments identiques ou similaires à ceux ainsi référencés sur la figure 1. Des moyens 6 sont prévus pour induire électromagnétiquement un courant $I_d$ dans la cellule, qui se superpose au courant $I_b$ qui est fourni par les moyens d'alimentation électrique à la cellule via éventuellement, d'autres cellules du même type. En effet, une cellule étant placée dans un réseau de telles cellules, ne reçoit que rarement du courant directement d'une alimentation électrique externe. Elle reçoit le courant, le plus souvent, d'autres cellules et le courant reçu dépend donc de l'état des autres.

La cellule transite quand l'intensité totale $I_t$ dans la cellule est supérieure à $I_c$ soit donc pour une intensité $I_b$ propre au réseau telle que

$$I_b = I_c - I_d$$

On a représenté en trait interrompu sur la figure 3, le déplacement du seuil de commutation de la cellule dû à cette injection de courant $I_d$. Comme représenté à la figure 2, cette injection de courant peut être obtenue par induction électromagnétique à partir d'au moins un conducteur 6 perpendiculaire au plan de la figure, dans lequel passe un courant $I_a$, ce conducteur étant placé au voisinage immédiat de la cellule.

La modulation de la position du seuil de commutation sous l'action d'un courant tel que $I_a$ rend l'utilisation de la cellule suivant l'invention dans un réseau "neuronal" particulièrement intéressante.

On sait qu'un tel réseau est composé de cellules partiellement ou complètement interconnectées, l'état de chaque cellule étant fonction de ceux des cellules avec lesquelles elle est interconnectée du côté de ses entrées, l'influence de chacune de ces cellules étant en outre caractérisée par un coefficient, appelé poids synaptique, appliqué au signal reçu d'une cellule émettrice.

Le courant $I_d$ induit dans la cellule selon l'invention par le courant $I_a$ circulant dans le conducteur 6 matérialise cette influence d'une cellule sur une autre.

On sait aussi que les réseaux neuronaux doivent subir un "apprentissage" pendant lequel on présente à leur entrée diverses expressions, sonores ou optiques par exemple, d'une même entité, les poids synaptiques s'ajustant alors progressivement pour que la sortie du réseau affiche une identification unique de cette entité, quelle que soit l'expression particulière de celle-ci présentée à l'entrée du réseau. C'est ainsi qu'un réseau neuronal peut être amené à reconnaître une lettre ou un chiffre, quelle que soit son expression manuscrite, variable d'une personne à une autre.

Aujourd'hui, cet apprentissage s'effectue principalement à l'aide d'un ordinateur "adjoint" simulant le réseau et procédant lui-même aux ajustements nécessaires des poids synaptiques. Cette technique "numérique" autorise un ajustement fin de ces poids mais présente le gros inconvénient de consommer beaucoup de temps d'ordinateur et donc d'être à la fois lente et coûteuse.

La cellule selon l'invention se prête au contraire à un ajustement "analogique" direct d'un réseau de telles cellules, comme c'est le cas dans les réseaux de Hopfield, ajustement obtenu alors beaucoup plus rapidement et à moindre coût. Un réseau de cellules selon l'invention présente cependant l'avantage d'être de structure beaucoup plus simple qu'un réseau de Hopfield, qui comporte un très grand nombre de composants semi-conducteurs.

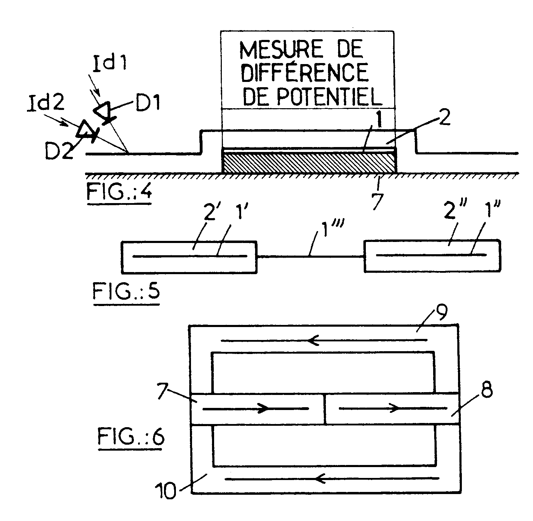

On a représenté à la figure 4 une variante de la cellule de la figure 2, qui s'en distingue en ce qu'on remplace l'injection par induction du courant $I_d$, par une injection directe d'un courant $I_{d1}$. Comme représenté, cette injection peut être multiple : $I_{d1}$, $I_{d2}$, et unidirectionnelle, comme illustré par les diodes $D_1$ et $D_2$. Une telle cellule à injection multiple peut être utilisée en porte logique du type ET ou OU, par exemple. Bien entendu une conduction undirectionnelle pourrait être établie aussi dans la cellule elle-même.

Comme on l'a vu plus haut, plusieurs cellules selon l'invention peuvent être connectées de manière à constituer un réseau neuronal. On a représenté aux figures 5 et 6 d'autres possibilités de connexion de telles cellules, données seulement à titre d'exemples non limitatifs. Les montages représentés présentent des propriétés intéressantes. Ainsi, les cellules (1', 2') et (1″, 2″) de la figure 5 sont interconnectées par une couche supraconductrice 1‴ qui couple les deux cellules lorsqu'elle est dans son état supraconducteur et qui isole ces deux cellules l'une de l'autre lorsqu'elle transite vers son état résistant.

A la figure 6 on a représenté quatre cellules selon l'invention, assemblées de manière que deux cellules en série 7, 8 soient connectées en parallèle avec chacune de deux autres cellules 9, 10. Les flèches indiquent la présence d'une diode qui fixe le sens du courant dans chaque cellule. Ainsi, la cellule 7 peut alimenter la cellule 8 qui peut à son tour alimenter les cellules 9 et 10. Cependant, les cellules 7 et 10 ne peuvent alimenter directement la cellule 9 et la cellule 8 ne peut alimenter la cellule 7.

Bien entendu, de nombreux autres agencements de cellules pourront être imaginés par l'homme de métier, en fonction de telle ou telle application recherchée.

La cellule selon l'invention décrite jusqu'ici fonctionne, en quelque sorte, en logique binaire, le courant passant totalement ou partiellement, respectivement, dans le canal supraconducteur. Un autre mode de réalisation de la cellule suivant l'invention présentant non pas un seul seuil de commutation mais plusieurs seuils étagés, présente à cet effet, dans la partie supraconductrice, plusieurs parties successives d'épaisseurs croissantes. L'intensité croissant, les parties supraconductrices transitent successivement. On comprend qu'un tel fonctionnement permet d'utiliser une cellule suivant l'invention en convertisseur analogique-numérique, en particulier, puisque l'intensité est générée par une tension.

On comprend maintenant que la cellule de commutation suivant l'invention permet d'atteindre les objectifs annoncés, à savoir un fonctionnement en commutation à des températures industriellement disponibles, et une structure simple se prêtant à la réalisation de portes logiques, de convertisseurs analogique-numérique et, également, de réseaux "neuronaux". Ces derniers, dans la structure simple obtenue grâce à la cellule suivant l'invention, sont susceptibles d'une grande variété d'applications telles que : identification de cible, reconnaissance de l'écriture manuscrite, reconnaissance de la parole, vision artificielle, etc... Comme on l'a vu plus haut, un tel réseau constitué avec des cellules conformes à la présente invention, peut subir un apprentissage "analogique" à l'instar des réseaux de Hopfield de constitution cependant beaucoup plus complexe. Il faut noter encore que la réalisation de cellules de commutation suivant l'invention ou de réseaux "neuronaux" de telles cellules, est possible à l'aide de techniques de gravure microlithographique bien connues et largement utilisées en microélectronique.

## Revendications

1. Cellule de commutation électrique, comprenant un premier canal (1) en un matériau présentant un état supraconducteur et un état résistant, des moyens de réfrigération pour maintenir ledit premier canal (1) à une température inférieure à celle qui assure la supraconductivité du matériau en dessous d'une intensité de courant critique dans le canal (1), des moyens d'alimentation électrique dudit canal (1) et des moyens pour régler l'intensité du courant électrique circulant dans le canal de manière à établir sélectivement le canal dans son état supraconducteur ou son état résistant, caractérisée en ce que la cellule comprend en outre un deuxième canal (2) en un matériau conducteur de l'électricité, électriquement connecté en parallèle sur le premier canal (1) de manière que la tension aux bornes du deuxième canal (2) soit sensiblement nulle lorsque le premier canal (1) est dans son état supraconducteur et non nulle lorsque le premier canal est dans son état résistant, lesdites bornes étant connectées à des moyens (5) de mesure de ladite tension, représentative de l'état de la cellule.

2. Cellule conforme à la revendication 1, caractérisée en ce qu'elle comprend des moyens (6) pour induire électromagnétiquement entre les bornes des canaux (1, 2) au moins un courant ($I_d$) contrôlé qui s'ajoute à celui ($I_b$) fourni par les moyens d'alimentation électrique via, le cas échéant, d'autres cellules du même type.

3. Cellule conforme à la revendication 1, caractérisée en ce qu'elle comprend des moyens pour injecter électriquement entre les bornes des canaux, au moins un courant ($I_d$) contrôlé qui s'ajoute à celui fourni par les moyens d'alimentation électrique via, le cas échéant, d'autres cellules du même type.

4. Cellule conforme à l'une quelconque des revendications 1 à 3, caractérisée en ce que les premier et deuxième canaux (1, 2) sont constitués de matériaux en couches minces étendues l'une sur l'autre, le deuxième canal (2) étant constitué d'un métal non supraconducteur de résistivité très inférieure à celle du matériau du premier canal (1) quand celui-ci est dans son état résistant.

5. Cellule conforme à l'une quelconque des revendications 1 à 4, caractérisée en ce que le premier canal (1) est constitué en un matériau supraconducteur à une température établie par des moyens de réfrigération à gaz industriel liquéfié.

6. Cellule conforme à la revendication 5, caractérisée en ce que ledit matériau supraconducteur est du type céramique.

7. Cellule conforme à la revendication 6, caractérisé en ce que ledit matériau supraconducteur est du type YBaCuO.

8. Cellule conforme à la revendication 5, caractérisée en ce que ledit matériau supraconducteur est du type alliage métallique.

9. Cellule conforme à la revendication 8, caractérisée en ce que ledit alliage métallique est du type NbTi.

10. Cellule conforme à l'une quelconque des revendications 2 à 9, caractérisée en ce qu'elle comprend des moyens de conduction unidirectionnelle (D1, D2) traversés par le courant circulant dans la cellule et/ou par un courant ($Id_1$, $Id_2$) induit ou injecté dans cette cellule.

11. Cellule conforme à l'une quelconque des revendications 1 à 10, caractérisée en ce que le premier canal comprend plusieurs parties connectées en série et présentant des sections prédéterminées croissant d'une partie à l'autre.

12. Utilisation de la cellule conforme à l'une quelconque des revendications 1 à 11, à la réalisation d'une porte logique.

13. Utilisation de la cellule conforme à l'une quelconque des revendications 1 à 11, à la réalisation d'un convertisseur analogique-numérique.

14. Utilisation de la cellule conforme à l'une quelconque des revendications 1 à 11, à la réalisation d'un réseau neuronal.

**Patentansprüche**

1. Elektrische Schaltzelle mit einem ersten Kanal (1) aus einem Material, das einen supraleitenden und einen Widerstandszustand hat, einer Einrichtung zum Kühlen, um den ersten Kanal (I) auf einer Temperatur unterhalb derjenigen zu halten, die die Supraleitfähigkeit des Materials unterhalb einer kritischen Stromstärke in dem Kanal (1) sichert, einer Einrichtung zur elektrischen Stromversorgung des Kanals (1) und einer Einrichtung zum Regeln der Intensität des in dem Kanal fließenden elektrischen Stroms, so daß der Kanal wahlweise in seinen supraleitenden oder seinen Widerstandszustand gebracht wird, dadurch gekennzeichnet, daß die Zelle außerdem einen zweiten Kanal (2) aus einem elektrisch leitfähigen Material aufweist, der elektrisch parallel zu dem ersten Kanal (1) geschaltet ist, so daß die Spannung an den Anschlüssen des zweiten Kanals (2) im wesentlichen null ist, wenn der erste Kanal (1) in seinem supraleitenden Zustand ist, und von null verschieden ist, wenn der erste Kanal in seinem Widerstandszustand ist, wobei die Anschlüsse mit einer Einrichtung (5) zum Messen der für den Zustand der Zelle repräsentativen Spannung verbunden sind.

2. Zelle nach Anspruch 1, dadurch gekennzeichnet, daß sie eine Einrichtung (6) zum elektromagnetischen Induzieren mindestens eines überwachten Stroms ($I_d$) zwischen den Anschlüssen der Kanäle (1, 2) aufweist, der zu dem Strom ($I_b$) hinzukommt, der von der Einrichtung zur elektrischen Stromversorgung, gegebenenfalls über andere Zellen gleicher Bauart, zugeführt wird.

3. Zelle nach Anspruch 1, dadurch gekennzeichnet, daß sie eine Einrichtung zum elektrischen Einspeisen mindestens eines überwachten Stroms ($I_d$) zwischen den Anschlüssen der Kanäle aufweist, der zu dem Strom hinzukommt, der von der Einrichtung zur elektrischen Stromversorgung, gegebenenfalls über andere Zellen gleicher Bauart, zugeführt wird.

4. Zelle nach einem der Ansprüche 1 bis 3, dadurch gekennzeichnet, daß der erste und der zweite Kanal (1, 2) aus aufeinander liegenden Dünnschichtmaterialien bestehen, wobei der zweite Kanal (2) aus einem nicht-supraleitenden Material mit einem spezifischen Widerstand besteht, der weit unterhalb desjenigen des Materials des ersten Kanals (1) liegt, wenn dieser in seinem Widerstandszustand ist.

5. Zelle nach einem der Ansprüche 1 bis 4, dadurch gekennzeichnet, daß der erste Kanal (1) aus einem Material besteht, das bei einer Temperatur supraleitend ist, die mittels einer Einrichtung zum Kühlen mit verflüssigtem Industriegas erzeugt wird.

6. Zelle nach Anspruch 5, dadurch gekennzeichnet, daß das supraleitende Material ein keramisches Material ist.

7. Zelle nach Anspruch 6, dadurch gekennzeichnet, daß das supraleitende Material ein YBaCuO-Material ist.

8. Zelle nach Anspruch 5, dadurch gekennzeichnet, daß das supraleitende Material eine Metallegierung ist.

9. Zelle nach Anspruch 8, dadurch gekennzeichnet, daß die Metallegierung NbTi ist.

10. Zelle nach einem der Ansprüche 2 bis 9, dadurch gekennzeichnet, daß sie in nur einer Richtung (D1, D2) leitende Einrichtungen aufweist, durch die der in der Zelle fließende und/oder ein in dieser Zelle induzierter oder eingespeister Strom ($Id_1$, $Id_2$) hindurchfließt.

11. Zelle nach einem der Ansprüche 1 bis 10, dadurch gekennzeichnet, daß der erste Kanal mehrere Teile aufweist, die in Serie geschaltet sind und vorbestimmte Abschnitte hat, die von einem Teil zum anderen übergehen.

12. Verwendung der Zelle nach einem der Ansprüche 1 bis 11 zur Verwirklichung eines logischen Gatters.

13. Verwendung der Zelle nach einem der Ansprüche 1 bis 11 zur Verwirklichung eines Analog/Digital-Wandlers.

14. Verwendung der Zelle nach einem der Ansprüche 1 bis 11 zur Verwirklichung eines neuronalen Netzwerks.

## Claims

1. Electrical switching cell, comprising a first channel (1) made of a material having a superconductive state and a resistive state, refrigeration means for maintaining the said first channel (1) at a temperature lower than that which ensures the superconductivity of the material below a critical current intensity in the channel (1), means for the supply of electrical power to the said channel (1) and means for regulating the intensity of the electric current circulating in the channel so as to selectively establish the channel in its superconductive state or its resistive state, characterised in that the cell also comprises a second channel (2) made of an electrically conductive material, electrically connected in parallel to the first channel (1) so that the voltage at the terminals of the second channel (2) is substantially zero when the first channel (1) is in its superconductive state, and non-zero when the first channel is in its resistive state, the said terminals being connected to means (5) for measuring the said voltage, representing the state of the cell.

2. Cell in accordance with Claim 1, characterised in that it comprises means (6) for inducing electromagnetically between the terminals of the channels (1, 2) at least one controlled current ($I_d$) which is added to the one ($I_b$) supplied by the electrical supply means via, where applicable, other cells of the same type.

3. Cell in accordance with Claim 1, characterised in that it comprises means for injecting electrically between the terminals of the channels at least one controlled current ($I_d$) which is added to the one supplied by the electrical supply means via, where applicable, other cells of the same type.

4. Cell in accordance with any one of Claims 1 to 3, characterised in that the first and second channels (1, 2) are formed from materials in thin layers spread over each other, the second channel (2) being formed from a non-superconductive metal whose resistivity is very much lower than that of the material of the first channel (1) when the latter is in its resistive state.

5. Cell in accordance with any one of Claims 1 to 4, characterised in that the first channel (1) is formed from a superconductive material at a temperature established by liquified commercial gas refrigeration means.

6. Cell in accordance with Claim 5, characterised in that the said superconductive material is of the ceramic type.

7. Cell in accordance with Claim 6, characterised in that the said superconductive material is of the YBaCuO type.

8.  Cell in accordance with Claim 5, characterised in that the said superconductive material is of the metal alloy type.

9.  Cell in accordance with Claim 8, characterised in that the said metal alloy is of the NbTi type.

10. Cell in accordance with any one of Claims 2 to 9, characterised in that it comprises unidirectional conduction means (D1, D2) through which the current circulating in the cell and/or a current ($Id_1$, $Id_2$) induced or injected into this cell passes.

11. Cell in accordance with any one of Claims 1 to 10, characterised in that the first channel comprises several parts connected in series and having predetermined cross sections increasing from one part to another.

12. Utilisation of the cell in accordance with any one of Claims 1 to 11 in the production of a logic gate.

13. Utilisation of the cell in accordance with any one of Claims 1 to 11 in the production of an analogue to digital converter.

14. Utilisation of the cell in accordance with any one of Claims 1 to 11 in the production of a neural network.

FIG.:1

MESURE DE DIFFÉRENCE DE POTENTIEL

R2    R3    R1

A    B    C    D

FIG.:2

Ia ⊙•

A    B    C    D

FIG.:3

$V_{BC}$

Id

Ic

I

MESURE DE
DIFFÉRENCE
DE POTENTIEL

FIG.:4

FIG.:5

FIG.:6